# EUROPEAN PATENT APPLICATION

(11) **EP 4 210 445 A1**
(43) Date of publication of application: **12.07.2023**
(21) Application number: 21864633.9
(22) Date of filing: 01.09.2021
(51) Int. Cl.: H05K 9/00

(54) **ELECTROMAGNETIC WAVE SHIELDING FILM**

(30) Priority: 03.09.2020 KR 20200112118
(71) Applicant: Miraenanotech Co., Ltd., Heungdeok-gu Cheongju-si, Chungcheongbuk-do 28122 (KR)
(72) Inventor: LEE, Bog Kyu, Cheongju-si, Chungcheongbuk-do 28122 (KR)
(74) Representative: Hancox, Jonathan Christopher
(86) International application number: PCT/KR2021/011730
(87) International publication number: WO 2022/050673

(57) **Abstract**

An electromagnetic wave shielding film according to one embodiment of the present invention comprises a substrate and an electrode pattern, which is provided on one surface of the substrate and contains metal particles, wherein the metal particles comprise first particles having sizes within a first range and second particles having sizes within a second range that is smaller than the first range, respectively, the number of second particles is greater than the number of first particles, and at least one first particle is mixed in among the second particles.

## Description

### TECHNICAL FIELD

The present invention relates to an electromagnetic wave shielding film, and more particularly, to an electromagnetic wave shielding film having an improved electromagnetic wave shielding rate and at the same time having high electromagnetic wave shielding performance even in various frequency bands of electromagnetic waves.

### BACKGROUND

Various kinds of electronic devices generate various harmful electromagnetic waves during its driving, and the harmful electromagnetic waves not only negatively affect the human body but also cause malfunction or propagation failure of a device other than the corresponding electronic device, thereby reducing product performance and reducing product life.

In particular, in most displays, since such harmful electromagnetic waves have a tendency to easily generate such harmful electromagnetic waves due to its operating characteristics, an electromagnetic wave shielding member is employed on the front surface of the display in order to block such harmful electromagnetic waves. The electromagnetic wave shielding member is required not to reduce a transparency of a display screen of the display in addition to a function of shielding the electromagnetic waves.

Meanwhile, a conventional electromagnetic wave shielding member used on the front surface of the display includes a metal mesh. In this case, a copper mesh in a film form formed through etching of copper foil has been generally used as the metal mesh.

In order to manufacture such a copper mesh film, a copper thin film forming process by plating, a blackening process for improving image quality, a surface irregularity process, an antioxidant process, and the like should be performed, and then, a copper foil should be adhered to a PET film and then, a photoresist coating, exposure, development, and etching should be performed on the copper foil using a photolithography method.

However, since such manufacturing method is complicated and perform a photolithography process or the like, there were problems in that in addition to the increase in manufacturing cost, 90% or more of the copper should be removed through etching, so that the material is also wasted.

In order to improve these problems, a method of manufacturing the electromagnetic wave shielding member using the following conductive paste has been proposed.

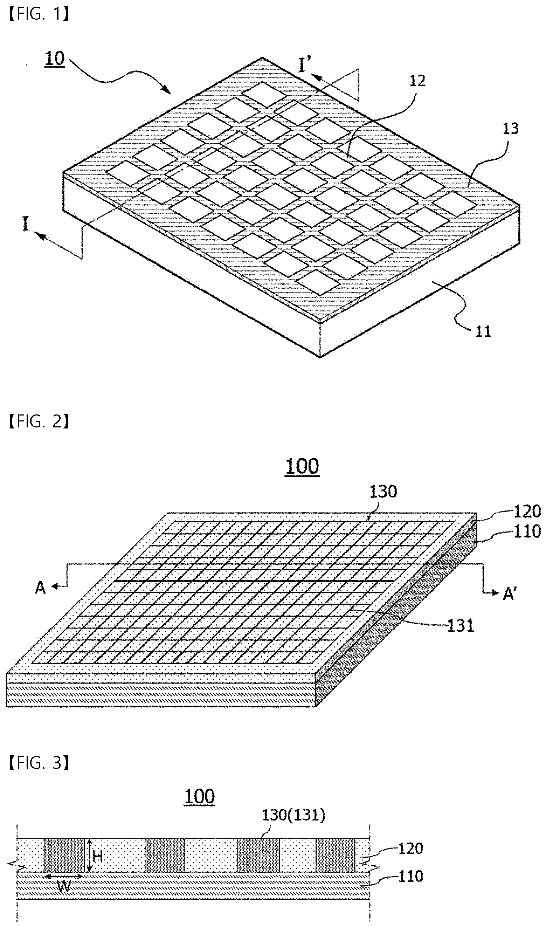

FIG. 1 illustrates a conventional electromagnetic wave shielding member 10 using a conductive paste.

The conventional electromagnetic wave shielding member 10 according to FIG. 1 includes a glass substrate 11, and an electromagnetic wave shielding pattern 12 and a ground electrode 13 respectively formed on one surface of the glass substrate 11. In this case, the electromagnetic wave shielding pattern 12 is formed by printing a conductive paste on the glass substrate 11 in an embossed pattern. That is, in the conventional electromagnetic wave shielding member 10, by forming the electromagnetic wave shielding pattern 12 using a conductive paste, the electromagnetic wave shielding performance could be realized more cheaply and simply.

However, in the case of the conventional electromagnetic wave shielding member 10 using the conductive paste, the shielding performance was not high, and particularly, there was a problem in that the shielding performance was shown only for some frequency band of electromagnetic waves.

In particular, as electronic devices become more complex and high-performance, not only higher electromagnetic wave shielding performance is required, but also higher electromagnetic wave shielding performance is required in various electromagnetic wave frequency bands. Therefore, there is a need for a technology more advanced than the related art that can meet these needs.

However, the matters described as the background art above are only for the purpose of improving understanding of the background of the present invention, and should not be taken as acknowledging that they correspond to related art already known to those skilled in the art of the present invention.

### SUMMARY

### Technical Problem

In order to solve the problems of the related art, the present invention is directed to providing an electromagnetic wave shielding film having high shielding performance even in various frequency bands of electromagnetic waves by increasing the conductivity of the conductive paste, thereby improving the electromagnetic wave shielding rate.

The technical problems to be achieved in the present invention are not limited to the technical problems mentioned above, and other technical problems not mentioned will be clearly understood by those of ordinary skill in the art from the following description.

### Technical Solution

An electromagnetic wave shielding film according to one embodiment of the present invention includes a substrate and an electrode pattern, which is provided on one surface of the substrate and contains metal particles, wherein the metal particles include first particles having sizes within a first range and second particles having sizes within a second range that is smaller than the first range, the number of second particles is greater than the number of first particles, and at least one first particle is mixed in among the second particles.

An electromagnetic wave shielding film according to another embodiment of the present invention includes a substrate; an electrode pattern, which is provided on one surface of the substrate and contains metal particles; and a transparent conductive layer provided on one surface of the electrode pattern or on the other surface of the substrate and covering the electrode pattern arranged along one surface of the substrate, wherein the metal particles include first particles having sizes within a first range and second particles having sizes within a second range that is smaller than the first range, the number of second particles is greater than the number of first particles, and at least one first particle is mixed in among the second particles.

The electrode pattern may include a first structure in which a plurality of second particles surround the first particle.

The electrode pattern may further include a second structure in which a plurality of second particles are connected.

The electrode pattern may include a greater number of the second structures than the number of the first structures.

The size of the first range may be 2 times or more larger than the size of the second ra nge.

The size of the first range may be 1 µm or more to 1.5 µm or less, and the size of the second range may be 400 nm or more to 450 nm or less.

The number ratio between the first particles and the second particles may be 2:8 to 4:6.

The electrode pattern may be formed in a mesh pattern shape comprising a plurality of polygons arranged along one surface of the substrate.

The plurality of polygons may include a plurality of irregular polygons adjacent to each other, and the irregular polygons may have different pitch values between adjacent irregular polygons.

The irregular polygon may have four or more vertexes, and a direction in which each of the sides extends may be different from each other.

The irregular polygon may have different angles formed by adjacent sides around each of the vertexes.

The electrode pattern may be formed along a groove formed on one surface of the substrate or on one surface of a resin layer provided on one surface of the substrate.

The electrode pattern may be formed in an embossed shape on one surface of the substrate.

The metal particles may be any one selected from silver (Ag), copper (Cu), aluminum (Al), nickel (Ni), and chromium (Cr), and the conductive layer may be any one selected from ITO, silver (Ag) nanotubes, graphene, carbon nanotubes, silver (Ag) particles, or a conductive polymer.

The electromagnetic wave shielding film according to one embodiment or another embodiment of the present invention may have a transparent substrate, so it can be employed as a light-transmitting screen device in a display.

### Advantageous Effects

The present invention configured as described above may not only exhibit improved electromagnetic wave shielding performance in any electromagnetic wave frequency band generated in the applied product, but also may integrally block electromagnetic waves in a complex product or various fields with a high shielding rate regardless of the frequency band.

In addition, if the electrode pattern according to the present invention includes the irregular polygon, a moire phenomenon may be avoided at all angles of a plane by preventing mutual interference with a pixel pattern of the display, and visibility may be improved. In addition, the irregular polygon may suppress pattern agglomeration of the electrode pattern to distribute the electrode pattern in a more balanced manner, thereby further enhancing the electromagnetic wave shielding effect.

The effects of the present invention are not limited to those mentioned above, and other effects not mentioned will be clearly understood by those of ordinary skill in the art from the following description.

### BRIEF DESCRIPTION OF THE DRAWINGS

FIG. 1 illustrates a conventional electromagnetic wave shielding member 10 using a conductive paste.
FIG. 2 illustrates a perspective view of an electromagnetic wave shielding film 100 according to a first embodiment of the present invention.
FIG. 3 illustrates a portion of a cross-sectional view of one side of the electromagnetic wave shielding film 100 according to the first embodiment of the present invention.
FIG 4. illustrates a portion of a top plan view of an electrode pattern 130 having a mesh pattern of a regular polygon 132 in the electromagnetic wave shielding film 100 according to the first embodiment of the present invention.
FIG. 5 illustrates a portion of a top plan view of an electrode pattern 130 having a mesh pattern of an irregular polygon 133 in the electromagnetic wave shielding film 100 according to the first embodiment of the present invention and an enlarged view thereof.
FIG 6 illustrates an example of a first structure 136A and a second structure 136B included in a pattern line 131 of the electrode pattern 130.
FIG. 7 illustrates various comparisons of the electromagnetic wave shielding film 100 according to the first embodiment of the present invention and a comparative example thereof, which are actually manufactured.
FIG 8 illustrates a graph of an electromagnetic wave shielding rate per frequency for the electromagnetic wave shielding film 100 according to the first embodiment of the present invention and the comparative example thereof, which are actually manufactured.
FIG. 9 illustrates a portion of a cross-sectional view of one side of an electromagnetic wave shielding film 200 according to a second embodiment of the present invention.
FIG. 10 illustrates a graph of an electromagnetic wave shielding rate per frequency for the electromagnetic wave shielding film 200 according to the second embodiment of the present invention and the comparative example thereof, which are actually manufactured.
FIG. 11 illustrates an example of a case in which the electromagnetic wave shielding film 100 according to the first embodiment of the present invention is applied as a screen device to a display.
FIG. 12 is a photograph contradistinctively showing an electrode pattern according to an embodiment of the present invention and a comparative example thereof.
FIG. 13 is a view contradistinctively showing characteristics of a screen device according to an embodiment of the present invention and a comparative example thereof.
FIG. 14 is a photograph for describing whether a moire phenomenon occurs in a screen device according to an embodiment of the present invention, and FIG. 15 is a photograph showing a display to which a screen device according to an embodiment of the present invention is applied.

### DETAILED DESCRIPTION OF THE EMBODIMENTS

The above-mentioned objects, means, and effects thereof of the present invention will become more apparent from the following detailed description in relation to the accompanying drawings, and accordingly, those skilled in the art to which the present invention belongs will be able to easily practice the technical idea of the present invention. In addition, in describing the present invention, when it is determined that a detailed description of a related known technology may unnecessarily obscure the subject matter of the present invention, the detailed description will be omitted.

The terms used in this specification are for the purpose of describing embodiments only and are not intended to limit the present invention. In this specification, the singular forms "a,", "an," and "the" also include plural forms in some cases unless otherwise specified in the context. In this specification, terms such as "include", "comprise", "provide" or "have" do not exclude the presence or addition of one or more other elements other than elements mentioned.

In this specification, terms such as "or" and "at least one", and the like may represent one of the words listed together or a combination of two or more thereof. For example, "A or B" and "at least one of A and B" may include only one of A or B, or may also include both A and B.

In this specification, descriptions according to "for example", etc. may not exactly match the information presented, such as the recited properties, variables, or values, and effects such as modifications, including tolerances, measurement errors, limits of measurement accuracy, and other commonly known factors should not limit the modes for carrying out the invention according to the various exemplary embodiments of the present invention.

In this specification, when an element is described as being "connected" or "linked" to another element, it will be understood that it may be directly connected or linked to the other element, but intervening elements may also be present. On the other hand, when an element is referred to as being "directly connected" or "directly linked" to another element, it will be understood that there are no intervening elements present.

In this specification, when an element is described as being "on" or "adjacent to" another element, it will be understood that it may be directly "on" or "connected to" the other element, but intervening elements may also be present. On the other hand, when an element is described as being "directly on" or "directly adjacent to" another element, it will be understood that there are no intervening elements present. Other expressions describing the relationship between the elements, for example, "between" and "directly between", and the like can be construed similarly.

In this specification, terms such as "first" and "second" may be used to describe various elements, but, the above elements should not be limited by the terms above. In addition, the above terms should not be construed as limiting the order of each element, and may be used for the purpose of distinguishing one element from another. For example, a "first element" may be named as a "second element" and similarly, a "second element" may also be named as a "first element."

Unless otherwise defined, all terms used in this specification may be used with meanings commonly understood by those of ordinary skill in the art to which the present invention belongs. In addition, terms defined in a commonly used dictionary are not interpreted ideally or excessively unless explicitly and specifically defined.

Hereinafter, preferred embodiments according to the present invention will be described in detail with reference to the accompanying drawings.

FIG. 2 illustrates a perspective view of an electromagnetic wave shielding film 100 according to a first embodiment of the present invention, and FIG. 3 illustrates a portion of a cross-sectional view of one side of the electromagnetic wave shielding film 100 according to the first embodiment of the present invention. That is, FIG. 3 shows a portion of a cross-section taken along line A-A' in FIG. 2.

The electromagnetic wave shielding film 100 according to the first embodiment of the present invention has electromagnetic wave shielding performance, and as shown in FIGS. 2 and 3, includes a substrate 110 and an electrode pattern 130. The electromagnetic wave shielding film 100 according to the first embodiment of the present invention may be employed in a front surface of a display and may function as a light transmissive screen device (hereinafter, referred to as a "screen device").

The substrate 110 may be a flat substrate and may be made of a non-conductive material. In the case of the screen device, the substrate 110 may be made of a transparent material that transmits light. In addition, the substrate 110 may be a glass substrate or a substrate of various resin materials formed in a film shape. For example, the substrate 110 of the resin material may include various resin materials such as polyethylene terephthalate (PET), polyethylene naphthalate (PEN), polyimide (PI), polycarbonate (PC), or polymethyl methacrylate (PMMA). The light transmittance of the substrate 110 may be 80% or more. At this time, the closer the light transmittance is to 100%, the better the light transmissibility, and the closer to 0%, the worse the light transmissibility.

The thickness of the substrate 110 may be about 10 µm or more to 250 µm or less. In this case, if the thickness of the substrate 110 is less than 10 µm, it may be difficult to form the electrode pattern 130 to a desired thickness on the substrate 110. Further, if the thickness of the substrate 110 exceeds 250 µm, the brightness of the screen device may be lowered than the desired brightness.

The electrode pattern 130 is made of a conductive material containing metal particles. The electrode pattern 130 may be formed in various patterns arranged in parallel on a plane along one surface of the substrate 110, and may perform a shielding function against electromagnetic waves passing around the electrode pattern. The electrode pattern 130 may have a form in which metal particles are cured through a binder resin. For example, the metal particles may include various conductive metal particles such as silver (Ag), copper (Cu), aluminum (Al), nickel (Ni), and chromium (Cr), and may have various sizes.

The electrode pattern 130 may be formed as an irregular mesh pattern when viewed from a plane. However, the electrode pattern 130 is not limited thereto, and may be formed in various patterns such as a regular mesh pattern, a regular or irregular line pattern, and a polygonal pattern when viewed from a plane.

The electrode pattern 130 may be formed in one surface direction of the substrate 110. That is, the electrode pattern 130 may be formed on one surface of the substrate 110 or on one surface of a resin layer 120 provided on one surface of the substrate 110. The resin layer 120 may be made of a transparent plastic material to transmit light. For example, the resin layer 120 may be made of a material different from the substrate 110 and may include various resin materials such as urethane acrylate and the like.

In order to form the electrode pattern 130 in one surface direction of the substrate 110, by imprinting the electrode pattern 130 using a mold having a shape corresponding to the electrode pattern 130, a concave intaglio groove corresponding to the electrode pattern 130 may be formed on one surface of the substrate 110 or the resin layer 120. Thereafter, the electrode pattern 130 having the corresponding intaglio groove shape may be formed by filling the formed intaglio groove with the conductive material. In this case, if the substrate 110 is a resin material substrate, the electrode pattern 130 may be formed on one surface of the corresponding substrate 110. In addition, if the substrate 110 is a resin substrate or a glass substrate, the electrode pattern 130 may be formed on one surface of the resin layer 120 after the resin layer 120 is applied to one surface of the substrate 110.

Specifically, a conductive paste formed of conductive metal particles and a binder is filled in an intaglio groove formed on one surface of the substrate 110 or the resin layer 120 using a blade, and then heat or ultraviolet rays or the like are applied to cure the conductive paste. Then, the remaining conductive paste remaining on the surface of the substrate 110 or the resin layer 120, which is not filled in the intaglio groove, is cleaned and then removed by a cleaning member, and then, the metal particles may be sintered through an additional heat treatment process to form the electrode pattern 130.

The electrode pattern 130 has been described as an example of a intaglio electrode method in which a conductive material is filled in an intaglio groove of one surface of the substrate 110 or the resin layer 120 to form the electrode pattern, but otherwise, an embossing electrode method protruding from one surface of the substrate 110 or the resin layer 120 to a predetermined thickness may be applied. In this case, the electrode pattern 130 may be formed by embossing a conductive paste with a gravure offset or the like on one surface of the substrate 110 or the resin layer 120. Of course, additionally, the conductive paste may be cured by applying heat or ultraviolet rays, and the metal particles may be sintered through subsequent heat treatment.

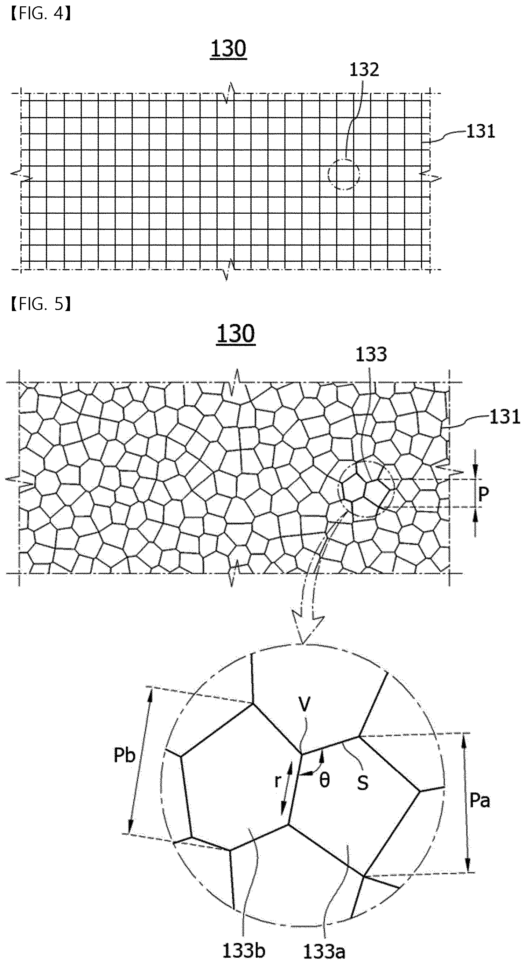

FIG 4. illustrates a portion of a top plan view of an electrode pattern 130 having a mesh pattern of a regular polygon 132 in the electromagnetic wave shielding film 100 according to the first embodiment of the present invention, and FIG. 5 illustrates a portion of a top plan view of an electrode pattern 130 having a mesh pattern of an irregular polygon 133 in the electromagnetic wave shielding film 100 according to the first embodiment of the present invention and an enlarged view thereof.

Meanwhile, the electrode pattern 130 may serve as a touch sensor. In this case, the electrode pattern 130 may be referred to as a pattern electrode, a detection electrode, a sensor layer, or an electrode layer.

Referring to FIGS. 4 and 5, the electrode pattern 130 may include a plurality of pattern lines 131. The plurality of pattern lines 131 may intersect with each other in various directions, thereby forming a plurality of regular polygons 132 or irregular polygons 133. That is, each side of the plurality of regular polygons 132 or irregular polygons 133 may be formed by the pattern line 131. Meanwhile, the pattern line 131 may be referred to as a thin conductive line.

When the pattern line 131 is formed in the intaglio electrode method of filling a conductive material in the intaglio of the substrate 110, each pattern line 131 may have a width W of about 4 µm or more to about 10 µm or less. In addition, each pattern line 131 may have a depth H of about 4 µm or more to about 10 µm or less. The cross-sectional shape of the pattern line 131 may be a rectangular shape. If the width W and depth H of the pattern line 131 are smaller than 4 µm, respectively, it may be difficult to manufacture the electrode pattern 130. If the width W and depth H of the pattern line 131 are larger than 10 µm, respectively, the light transmissibility of the electrode pattern 130 may be affected, and the screen visibility of the display to which the screen device is applied may be deteriorated. Meanwhile, as the width W and the depth H of the pattern line 131 are closer to 4 µm, respectively, the light transmissibility of the electrode pattern 130 becomes improved, and as the width H and the depth H are closer to 10 µm, a change in capacitance caused by a user's touch may be accurately detected.

When the pattern line 131 is formed in the embossing electrode method protruding from one surface of the substrate 110 or the resin layer 120, the width of the pattern line 131 may be about 0.5 µm or more to about 10 µm or less, and the thickness may be about 0.2 µm to about 5 µm or less. The cross-sectional shape of the pattern line 131 may be a rectangular shape.

A plurality of regular polygons 132 or irregular polygons 133 are arranged along the top surface of the substrate 110 to form an electrode pattern 130. That is, the electrode pattern 130 may include a plurality of regular polygons 132 or irregular polygons 133 formed by crossing regular or irregular thin conductive lines. Here, the regular means a regular shape, and the irregular means an irregular shape. That is, the irregular may be an irregular shape in which, although the shape is determined to be a predetermined shape, a regularly repeated pattern cannot be derived from the predetermined shape. Accordingly, a plurality of irregular polygons 133 may have different shapes. However, it may be preferable that the electrode pattern 130 includes a plurality of irregular polygons 133 to facilitate moire avoidance.

Each of the plurality of irregular polygons 133 has a pitch value P within a preset range. In addition, the irregular polygons 133 adjacent to each other may have different pitch values P. At this time, the pitch value P means the maximum value among the distance values between vertexes V of the irregular polygon 133. A detailed description of the plurality of irregular polygons 133 will be described later.

Meanwhile, the shielding performance of the electrode pattern 130 may be affected according to the size range of the metal particles exhibiting conductivity. In this case, the size of the metal particle may be the maximum length among the lengths from one side to the other side of the metal particle, but the present invention is not limited thereto.

That is, in the case of a conventional electrode pattern, only metal particles having a similar size range were included, and thus the shielding performance was limited. That is, in the case of a conventional electrode pattern, the shielding performance was not high, and in particular, the shielding performance was exhibited only for some frequency bands of electromagnetic waves.

In order to improve this, the present invention forms an electrode pattern 130 by mixing different sizes of metal particles in a conductive paste. Accordingly, the electrode pattern 130 can increase the electromagnetic wave shielding rate by increasing the filling density of the metal particles, thereby improving the conductivity and lowering the resistance. That is, since the conductive increases as the area of the metal particles which are the material of the electrode pattern 130 contact each other, when small-sized metal particles and large-sized metal particles are mixed therebetween, the contact area between the particles increases and the filling weight of the metal particles in the same space can be increased, resulting in a lowering of the overall resistance. As a result, the electromagnetic wave shielding rate of the electromagnetic wave shielding film 100 may be further improved due to the lowered electrical resistance of the electrode pattern 130.

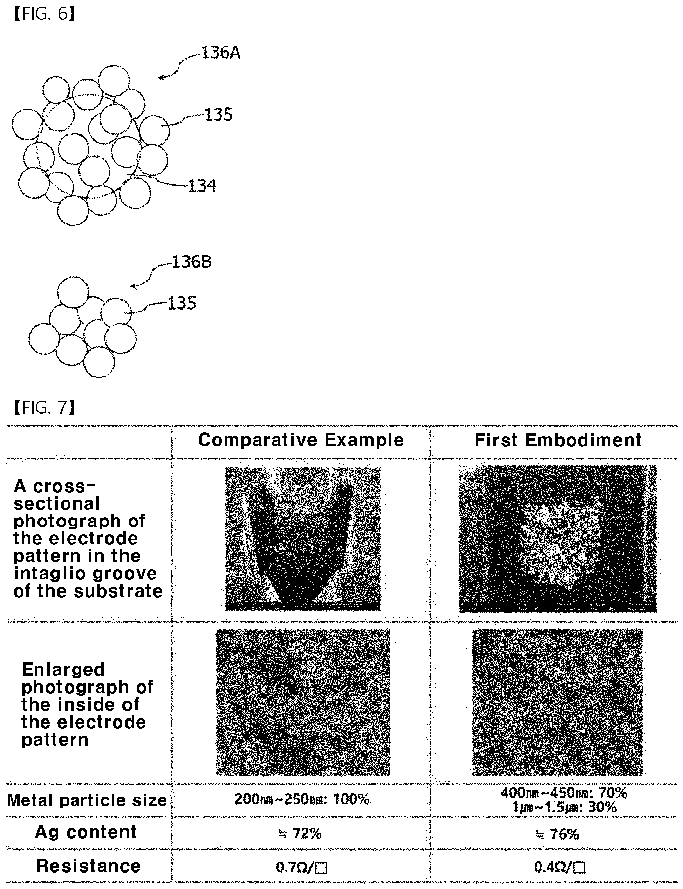

FIG 6 illustrates an example of a first structure 136A and a second structure 136B included in a pattern line 131 of the electrode pattern 130.

Specifically, referring to FIG. 6, the pattern line 131 of the electrode pattern 130 includes a plurality of first particles 134 having a size in a first range and a plurality of second particles 135 having a size in a second range, respectively. In this case, the second range is a size range smaller than the first range. That is, the size of the first particles 134 is larger than the size of the second particles 135. Of course, the sizes of the first particles 134 may be different from each other, and the sizes of the second particles 135 may be different from each other.

In particular, the electrode pattern 130 may include a first structure 136A in which at least one second particle 135 is sintered and mixed with the first particle 134. Since the first structure 136A has a structure in which the second particles 134 of small size surround the first particles 135 of large size, the contact area between the particles can be increased, and thus shielding performance can be improved.

In this case, since the first structure 136A in which the second particles 135 surround the first particles 134 should be included, the conductive paste preferably includes more second particles 135 than first particles 134. That is, the electrode pattern 130 preferably includes more second particles 135 than first particles 134.

In addition, since the second particles 135 are included more than the first particles 134, the electrode pattern 130 may further include a second structure 136B in which the plurality of second particles 135 are electrically connected. The second structure 136B may be electrically connected to the first structure 136A. In this case, since shielding performance is greatly improved by the first structure 136A, it may be preferable that the electrode pattern 130 includes more of the first structure 136A than the second structure 136B. However, in some cases, for example, as the number of large-sized first particles 134 increases, if the filling is not smooth in the intaglio groove, or if the particles need to be filled in the narrow intaglio groove due to the required product characteristics, the number of large first particles 134 should be reduced, and thus the electrode pattern 130 may include more of the second structure 136B than the first structure 136A.

The first structure 136A and the second structure 136B may be finally generated during the curing and sintering process of the conductive paste. In particular, each of the particles 134 and 135 in the conductive paste is partially melted by heat transferred in the sintering process, and thus the particles around the conductive paste are electrically connected, so that the first structure 136A or the second structure 136B may be generated.

It may be preferable that the size of the first range is about 2 times or more to about 4 times or less larger than the size of the second range. For example, the size of the first range may be 1 µm or more to 1.5 µm or less, and the size of the second range may be 400 nm or more to 450 nm or less. If the size of the first range is less than two times the size of the second range, the number of second particles 135 surrounding the first particles 134 is too small, and there is a limit to increasing the contact area between the particles. In addition, if the size of the first range exceeds 4 times the size of the second range, the difference in size and weight between the first particles 134 and the second particles 135 is so great that when mixing the metal particles, the first particles 134 tend to be not evenly dispersed in the second particles 135 and clump together, and thus fillability may not be good when filling into the intaglio groove.

Meanwhile, the mixing ratio between the first particles 134 and the second particles 135 may have a great influence on the electrical resistance and the shielding performance of the electrode pattern 130. Accordingly, the number ratio between the first particles 134 and the second particles 135 (the number of first particles:the number of second particles) may be preferably 2:8 to 4:6.

That is, if the first particles 134 are smaller than the number ratio of 2:8, the number of the first particles 134 is too small, so that the number of the first structures 136A in the pattern line 131 is not sufficient, and thus the shielding performance may decrease. In addition, when the conductive paste is filled in the intaglio groove, the filling weight density of the metal particles 134 and 135 in the same space is relatively low, so that the electrical resistance can be relatively high.

Meanwhile, if the number of first particles 134 is greater than the number ratio of 4:6, the number of the second particles 135 to surround the first particles 134 is insufficient, so that the size of first structure 136A is too small, and thus the shielding performance may decrease. In addition, when the conductive paste is filled in the intaglio groove, there is a high probability that an empty space will be created in the intaglio groove due to interference between the large first particles 134, resulting in a decrease in fillability and an increase in electrical resistance.

In consideration of this, the optimum number ratio between the first particles 134 and the second particles 135 may be 3:7. That is, considering a high filling weight density while increasing the contact area between the first and second particles 134 and 135 filled in the intaglio groove, if the number ratio between the first particles 134 and the second particles 135 is 3:7, it may be effective to implement low resistance and to improve the shielding performance for the electrode pattern 130.

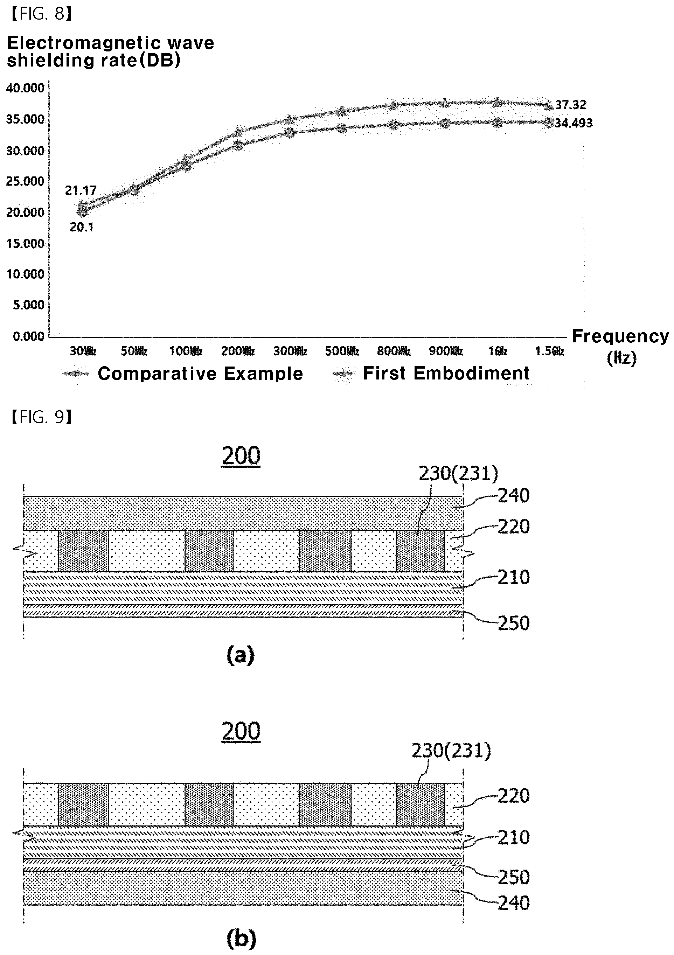

FIG. 7 illustrates various comparisons of the electromagnetic wave shielding film 100 according to the first embodiment of the present invention and a comparative example thereof, which are actually manufactured, and FIG 8 illustrates a graph of an electromagnetic wave shielding rate per frequency for the electromagnetic wave shielding film 100 according to the first embodiment of the present invention and the comparative example thereof, which are actually manufactured. That is, in FIG. 8, the x-axis represents a frequency, and the y-axis represents an electromagnetic wave shielding rate, the unit of which is decibel (DB).

Meanwhile, for performance experiments, an electromagnetic wave shielding film 100 according to the first embodiment of the present invention was manufactured. Specifically, after applying the resin layer 120 of the urethane acrylate resin on the transparent PET substrate 110, the resin layer is imprinted with a mold having an embossed pattern to form a groove of the intaglio pattern. Then, a conductive paste of silver (Ag) particles was filled in the intaglio groove, followed by curing and surface cleaning, and heat treatment and sintering, thereby forming the electrode pattern 130 of the mesh pattern. In this case, each pattern line 131 of the electrode pattern 130 filled in each intaglio groove has the same width W and depth H. The silver (Ag) particles included in the conductive paste include 30% of the first particles 134 of 1 µm or more to 1.5 µm or less, and 70% of the second particles 135 of 400 nm or more to 450 nm or less.

In addition, for performance comparison, a conventional shielding film (Comparative Example) was manufactured. In this case, the conventional shielding film has a structure of the same substrate, resin layer, and electrode pattern as the electromagnetic wave shielding film 100 according to the first embodiment of the present invention. That is, the electrode pattern of the comparative example is manufactured according to the imprinting of the same mold and the conductive paste filling, and has the same mesh pattern as in the first embodiment. However, an electrode pattern was formed using a conductive paste including silver (Ag) particles having a metal particle size of 200 nm or more to 250 nm or less. That is, in the comparative example, an electrode pattern was formed using silver (Ag) particles having a substantially similar size.

In FIGS. 7 and 8, the first embodiment shows an electromagnetic wave shielding film 100 according to the first embodiment of the present invention manufactured, and the comparative example shows the conventional electromagnetic wave shielding film manufactured.

Referring to FIG. 7, as can be seen from the cross-sectional view of the electrode pattern and its enlarged view, the first embodiment includes the first structures 136A, while the comparative example includes only the second structures 136B without the first structures 136A. That is, the electrode pattern 130 of the first embodiment has a first particle 134 having a large size positioned between the second particles 135 having a small size, and the metal particles are distributed such that the first particles 134 surround the second particles 135.

That is, when the size of the metal particles of the electrode pattern 130 is different, and particularly, the first particles 134 having a large size and the second particles 135 having a small size were mixed at a ratio of 3:7 as in the first embodiment, the amount of silver (Ag) in the same space was increased by about 4% than that of the comparative example. That is, it was confirmed that the fillability of the metal particles according to the first embodiment was improved. In addition, sheet resistance of the electrode pattern was measured in the same section. As a result, it was confirmed that in the case of the first embodiment (about 0.4 Ω□, where □ is an area and represents cm²), the resistance decreased by about 0.3 Ω□ in the case of the comparative example (about 0.7 Ω□).

As a result, in the case of the first embodiment, the filling weight density may be relatively increased as the fillability of the metal particles due to the mixing of the first particles 134 and the second particles 135 is improved, and thus the electrical resistance may be relatively lowered.

In addition, for the first embodiment and the comparative example, the shielding rate was measured for each frequency. That is, referring to FIG. 8, it can be seen that the graph of the first embodiment has a higher shielding rate than the graph of the comparative example in the entire frequency band. In particular, the graph of the first embodiment increases more of the electromagnetic wave shielding rate in the high frequency band, but increases by about 3 dB relative to the graph of the comparative example. That is, as in the first embodiment, it can be seen that the electrode pattern 130 formed by mixing large and small metal particles with a set range becomes improved in fillability, and as a result, the resistance becomes lowered, so that the electromagnetic wave shielding rate for the entire frequency band is increased.

FIG. 9 illustrates a portion of a cross-sectional view of one side of an electromagnetic wave shielding film 200 according to a second embodiment of the present invention.

The electromagnetic wave shielding film 200 according to the second embodiment of the present invention has electromagnetic wave shielding performance, and as shown in FIG. 9, may include a substrate 210, a resin layer 220, an electrode pattern 230, a conductive layer 240, and a hard coating layer 250. In this case, the substrate 210, the resin layer 220, the electrode pattern 230, and a pattern line 231 are the same as the substrate 110, the resin layer 120, the electrode pattern 130, and the pattern line 131 of the electromagnetic wave shielding film 100 according to the first embodiment of the present invention, which is described above or will be described later, and thus a detailed description thereof will be omitted. Of course, the electromagnetic wave shielding film 100 according to the second embodiment of the present invention may function as a screen device.

In particular, the electromagnetic wave shielding film 200 according to the second embodiment of the present invention has a high electromagnetic wave shielding performance even when electromagnetic waves generated in the electronic device are not only a high frequency band but also a low frequency band, and such a shielding performance may be implemented through a conductive layer 240 having a high conductivity additionally provided at the upper or lower portions of the electrode pattern 230.

That is, the conductive layer 240 is formed of a conductive material and the conductive layer 240 may have an area covering an area of the electrode pattern 230 arranged along one surface of the substrate 210. Referring to FIG. 9, the conductive layer 240 may be formed in one surface direction of the electrode pattern 230 (see FIG. 9(a)) or the other surface direction of the substrate 210 (see FIG. 9(b)). In addition, the conductive layer 240 may be formed in both one surface direction of the electrode pattern 230 and the other surface direction of the substrate 210.

For example, the conductive layer may include ITO, silver (Ag) nanotubes, graphene, carbon nanotubes, silver (Ag) particles, or a conductive polymer such as poly(3,4-ethylenedioxythiophene)polystyrene sulfonate (PEDOT:PSS), but is not limited thereto. In addition, in the case of the screen device, the conductive layer 240 may be made of a transparent conductive material such as ITO so that a display image may be transmitted.

For example, the thickness of the conductive layer 240 may be about 80 µm or more to 200 µm or less, and the sheet resistance may be preferably about 50 Ω□ or more to about 200 Ω□ or less, and the sheet resistance may be more preferably about 100 Ω□ or more to about 150 Ω□, so that electromagnetic wave optimal shielding rate performance can be obtained. However, as the conductive layer 240 is made of a material having a high conductivity, the degree of reflection of the electromagnetic wave may be further increased to further improve the electromagnetic wave shielding rate.

Meanwhile, the hard coating layer 250 may be formed on the other surface of the substrate 210. The hard coating layer 250 may be selectively applied to prevent scratch damage of the substrate 210. That is, when the conductive layer 240 is formed in the other surface direction of the substrate 210 (see FIG. 9(b)), the conductive layer 240 may be formed on the other surface of the hard coating layer 250.

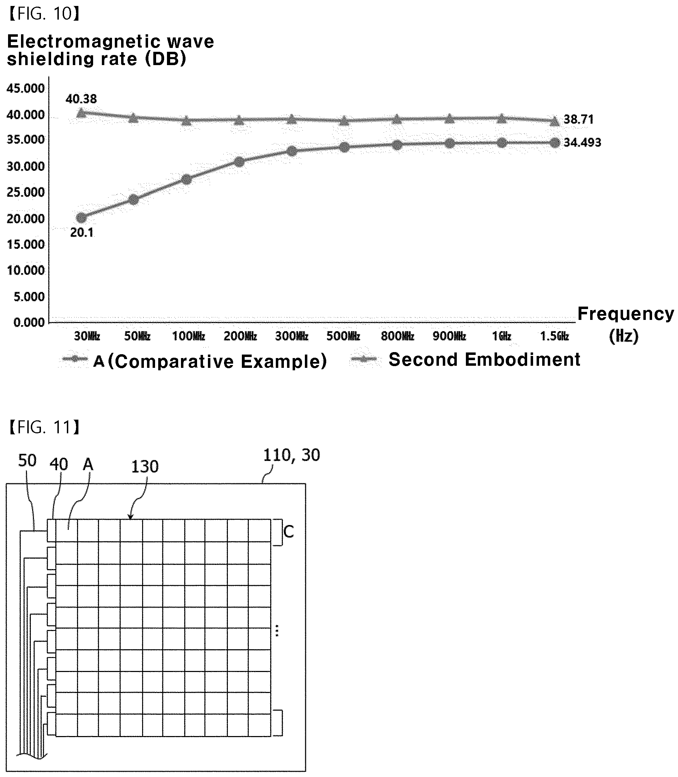

FIG. 10 illustrates a graph of an electromagnetic wave shielding rate per frequency for the electromagnetic wave shielding film 200 according to the second embodiment of the present invention and the comparative example thereof, which are actually manufactured.

Meanwhile, for performance experiments, an electromagnetic wave shielding film 200 according to the second embodiment of the present invention was manufactured. Specifically, in the first embodiment made in FIGS. 7 and 8, the conductive layer 240 was additionally formed. That is, a conductive layer 240 of an ITO having a sheet resistance of about 150 Ω□ was deposited on one side of the electromagnetic wave shielding film 100 of the first embodiment. In FIG. 10, the second embodiment illustrates an electromagnetic wave shielding film 200 according to the second embodiment of the present invention manufactured. In addition, for performance comparison, comparative examples made in FIGS. 7 and 8 were used.

For the second embodiment and the comparative example, the shielding rate was measured for each frequency. That is, referring to FIG. 10, it can be seen that the electromagnetic wave shielding film 200 of the second embodiment has a shielding rate increased from a minimum of about 4dB to a maximum of about 20dB compared to the electromagnetic wave shielding film of the comparative example. In particular, it can be seen that the electromagnetic wave shielding rate is greatly improved in the low frequency region.

That is, as the electromagnetic wave shielding film 200 according to the second embodiment of the present invention includes an electrode pattern 230 in which metal particles of the first particles 134 having a large size and the second particles 135 having a small size are mixed, and further includes a conductive layer 240, it can be seen that it has a uniform and high shielding rate from a low frequency band to a high frequency band.

FIG. 11 illustrates an example of a case in which the electromagnetic wave shielding film 100 according to the first embodiment of the present invention is applied as a screen device to a display.

A screen device according to an embodiment of the present invention is a light-transmitting screen device, and includes the electromagnetic wave shielding film 100 according to the first embodiment of the present invention to enable at least one of a touch input and an electromagnetic wave shielding. In addition to the electromagnetic wave shielding film 100 according to the first embodiment of the present invention, the screen device according to an embodiment of the present invention may further include a protective substrate 30, a connector 40, and a peripheral wiring 50. Such a screen device may include a plurality of sets (for example, two sets, and the like) of the electromagnetic wave shielding film 100, the protective substrate 30, the connector 40, and the peripheral wiring 50, and these sets may be stacked up and down and laminated to each other.

The screen device according to an embodiment of the present invention may be disposed on a front surface of a display, may be variously used as at least one of a touch screen device and an electromagnetic wave shielding device, and may also be used in a vehicle window or a building window.

In this case, the substrate 110 may be made of a transparent material that transmits light, and the lower surface of the substrate 110 may be stacked on a display panel. The electrode pattern 130, the connector 40, and the peripheral wiring 50 may be formed on the top surface of the substrate 110, and the top surfaces thereof may be protected by the protective substrate 30. The top surface of the protective substrate 30 may be protected with a glass substrate (not shown). The area of the substrate 110 may be larger than the screen area of the display to which the screen device is to be applied, or may be equal to the screen area described above.

Meanwhile, when serving as a touch sensor, a region on the substrate 110 in which the electrode pattern 130 is formed may be a channel region, a touch region, or an active region, and the remaining region may be a peripheral region. The channel region may include a plurality of channel sections C. The electrode pattern 130 formed in each of the channel sections C may be electrically insulated from the electrode pattern 130 in the neighboring channel sections C by disconnection or the like. That is, in the electrode pattern 130, a plurality of disconnection lines separating the above-described channels in a predetermined direction may be formed so that a plurality of electrically conductive channels are formed. This disconnection line means a portion disconnected from the outside of each channel. Meanwhile, the shape and arrangement of the channel section C may be varied.

In addition, the electrode pattern 130 of the electromagnetic wave shielding film 100 may include a plurality of irregular polygons 133. In addition, each of the plurality of irregular polygons 133 has a pitch value P within a preset range, and neighboring irregular polygons 133 have different pitch values P from each other.

The protective substrate 30 may be formed to cover a top surface of the electromagnetic wave shielding film 100. The protective substrate 30 may be in a film shape. The protective substrate 30 may include an optical clear adhesive (OCA) material and may be optically transparent. The protective substrate 30 may be referred to as a protective sheet, an adhesive sheet, or an adhesive film.

A connector 40 and a peripheral wiring 50 may be formed in a peripheral region on the transparent substrate 110. The connector 40 may be electrically connected to the electrode pattern 130, and the peripheral wiring 50 may connect the connector 40 with an external circuit (not shown). The touch signal detected by the electrode pattern 130 may be transmitted to the external circuit through the connector 40. The connector 40 and the peripheral wiring 50 described above may include at least one of indium tin oxide (ITO), copper (Cu), and silver (Ag) materials.

Of course, the screen device may include the electromagnetic wave shielding film 200 according to the second embodiment of the present invention instead of the electromagnetic wave shielding film 100 according to the first embodiment of the present invention. However, the description thereof will be omitted.

Hereinafter, a screen device according to an embodiment of the present invention will be described in detail.

Hereinafter, a plurality of irregular polygons 133 provided in the electrode pattern 130 according to the first embodiment of the present invention will be described in more detail with reference to FIG. 4. However, this description may be applied to the electrode pattern 230 according to the second embodiment of the present invention as it is.

The plurality of irregular polygons 133 may have four or more vertexes V, respectively. For example, the irregular polygons 133 may be a polygon having a quadrangle or more among polygons. For example, when preparing an irregular polygon of a triangle having the same pitch value and an irregular polygon of a quadrangle or more, the irregular polygon of the triangle has a smaller area than the irregular polygon of the quadrangle or more, and the irregular polygon of the triangle does not have a sufficient size than the pixel area of the display, so that the pixel and the irregular polygon of the triangle may be optically interfered. When the irregular polygon 133 is formed as a polygon having a quadrangle or more, since the area thereof is larger relative to the same pixel value, optical interference between the irregular polygon 133 and the pixel can be suppressed or prevented.

The irregular polygon 133 may have various shapes such as a quadrangle, a pentagon, a hexagon, and the like. Hereinafter, embodiments of the present invention will be described in detail with reference to the pentagonal irregular polygon 133.

For example, the irregular polygon 133 formed to have five vertexes V and five sides S may include a first vertex, a second vertex, a third vertex, a fourth vertex, and a fifth vertex, and a first side, a second side, a third side, a fourth side, and a fifth side. The irregular polygons 133 may have different directions r in which each side S extends. That is, the first direction in which the first side is extended, the second direction in which the second side is extended, the third direction in which the third side is extended, the fourth direction in which the fourth side is extended, and the fifth direction in which the fifth side is extended may be different directions. In addition, the irregular polygon 133 may have different angles θ formed by neighboring sides S around each vertex V. Accordingly, it is possible to fundamentally prevent the boundary line between the irregular polygons 133 from appearing more prominently than the surroundings while forming a certain pattern. For example, if the irregularity of the irregular polygons 133 is excessive, a foreign body sensation may occur on the electrode pattern 130, but the irregular polygons 133 according to the first embodiment of the present invention can prevent the foreign body sensation.

Meanwhile, in the irregular polygon 133, distance values between vertexes V may be different from each other within a predetermined size range. That is, the distance value between the first vertex and the second vertex, the distance value between the second vertex and the third vertex, the distance value between the third vertex and the fourth vertex, the distance value between the fourth vertex and the fifth vertex, and the distance value between the fifth vertex and the first vertex may all be included within a predetermined size range and may have different sizes from each other. Accordingly, it is possible to prevent each irregular polygon 133 from being noticeably distorted in shape relative to its surroundings, and to suppress or prevent the non-specific irregular polygon 133 from being conspicuous relative to its surroundings. The plurality of irregular polygons 133 formed as described above may have different shapes between adjacent irregular polygons 133. Specifically, a first irregular polygon 133a and a second irregular polygon 133b adjacent to each other may have different shapes. In this case, the pitch value Pa of the first irregular polygon 133a and the pitch value Pb of the second irregular polygon 133b may be different from each other. The pitch values P, Pa, and Pb mean maximum values among distance values between vertexes V of the irregular polygon 133.

The pitch value P of each of the plurality of irregular polygons 133 may be determined according to the light transmittance and sheet resistance of the electrode pattern 130. Specifically, the pitch value P of each of the plurality of irregular polygons 133 may be determined such that the light transmittance of the electrode pattern 130 is 80% or more and the sheet resistance of the electrode pattern 130 is about 10 Ω/cm² or less. For example, the pitch value of the irregular polygon 133 may have a lower limit value that is any one value selected from values such that the light transmittance of the electrode pattern 130 is about 80% or more, and an upper limit value that is any one value selected from values such that the sheet resistance of the electrode pattern 130 is about 10 Ω/cm² or less. Here, the upper limit of the light transmittance of the electrode pattern 130 may be less than about 100%, and the lower limit of the sheet resistance of the electrode pattern 130 may be about 0.1 Ω/cm² or more. According to the description above, the lower limit value and the upper limit value of the pitch value P of the irregular polygon 133 may be selected within a range of about 70 µm or more and about 650 µm or less.

Meanwhile, the lower limit value of the pitch values P of the plurality of irregular polygons 133 may be about 70% of the reference pitch value, and the upper limit value may be about 130% of the reference pitch value. That is, the upper limit value and the lower limit value of the plurality of irregular polygons 133 may be determined based on the size of a predetermined reference pitch value, and thus, the plurality of irregular polygons 133 may have a deviation of about ±30% from the reference pitch value. Specifically, the minimum pitch value may have a deviation of about -30% and the maximum pitch value may have a deviation of about +30% with respect to the reference pitch value. That is, the upper limit value and the lower limit value of the pitch values of the plurality of irregular polygons 133 may be determined by the reference pitch value. That is, the reference pitch value means a pitch value that is a reference for determining the upper limit value and the lower limit value of the pitch value.

For example, among the pitch values of the plurality of irregular polygons 133, the minimum pitch value may be 0.7 times the reference pitch value, and the maximum pitch value may be 1.3 times the reference pitch value. Accordingly, it is possible to prevent each irregular polygon 133 from being more prominent in size than its surroundings, and to suppress or prevent the non-specific irregular polygon 133 from being conspicuous relative to its surroundings.

That is, if the deviation between the upper limit value and the lower limit value for the reference pitch value exceeds the above-described deviation, when an irregular polygon with a minimum pitch value and an irregular polygon with a maximum pitch value are adjacent to each other, due to the size difference between them, the boundary may appear more prominent than the surroundings, and a foreign body sensation may occur. On the other hand, if the deviation between the upper limit value and the lower limit value for the reference pitch value is within the above range, even if an irregular polygon having a minimum pitch value and an irregular polygon having a maximum pitch value are adjacent to each other, the boundary may not be more prominent than the surroundings, and a foreign body sensation may be prevented from occurring.

The reference pitch value may be determined to be the same as or similar to a pixel size of a display to which the screen device is to be applied within a predetermined range of a pitch value such that a minimum pitch value and a maximum pitch value determined by the reference pitch value may be included within a size range of a pitch value P such that a light transmittance of the electrode pattern 130 is about 80% or more and a sheet resistance of the electrode pattern 130 is about 10 Ω/cm² or less. If the light transmittance of the electrode pattern 130 is less than about 80%, it is difficult to accurately view a screen output from a display device disposed below the electrode pattern 130. If the sheet resistance of the electrode pattern 130 exceeds about 10 Ω/cm², touch recognition sensitivity of the electrode pattern 130 may be reduced.

The above-described reference pitch value may be any one value selected from about 100 µm or more to about 500 µm or less. In this case, if the size of the reference pitch value is less than about 100 µm, the minimum pitch value may be less than about 70 µm in size, and the light transmissibility of the electrode pattern 130 may be lowered to less than about 80% due to the irregular polygons having the minimum pitch value. If the size of the reference pitch value exceeds about 500 µm, the size of the maximum pitch value may exceed about 650 µm, and the sheet resistance of the electrode pattern 130 may be greater than about 10 Ω/cm² due to the irregular polygons having the maximum pitch value.

Meanwhile, the irregular polygon 133 may improve the light transmissibility of the electrode pattern 130 as the pitch value P increases. In addition, sheet resistance of the electrode pattern 130 may decrease as the pitch value P of the irregular polygon 133 decreases.

Therefore, in the irregular polygon 133, the size of the reference pitch value and the range of pitch values P according to the light transmissibility and sheet resistance required for the electrode pattern 130 can be determined as described above, and transmittance and sheet resistance of the electrode pattern 130 including the irregular polygons 133 may be maintained at a desired high level. Meanwhile, if the light transmissibility of the electrode pattern 130 deteriorates, it may be difficult for the screen device to accurately view the screen output from the display, and if the sheet resistance of the electrode pattern 130 increases, touch recognition sensitivity may be reduced.

As described above, if a non-specific portion of the irregular polygons 133 constituting the electrode pattern 130 is relatively larger or smaller in size than its surroundings, the corresponding portion may appear more prominent than its surroundings. Accordingly, the range of the pitch value P of the irregular polygons 133 according to the first embodiment of the present invention is specifically exemplified as follows.

### (Embodiment 1)

The lower limit value of a pitch value P of an irregular polygon 133 is about 70 µm, and the upper limit value is about 130 µm, and in this case, the reference pitch value may be about 100 µm. The shape or size of each irregular polygon 133 may be determined within the range of the pitch value P. Accordingly, a plurality of irregular polygons 133 may have pitch values P of various sizes different from each other within a range of pitch value P of about 70 µm or more to about 130 µm or less. From this, it is possible to prevent the formation of a predetermined shape having a specific regularity in the electrode pattern 130 while preventing excessive irregularity of the irregular polygons 133.

### (Embodiment 2)

The lower limit value of the pitch values P of the plurality of irregular polygons 133 is about 140 µm, and the upper limit value is about 260 µm, and in this case, the reference pitch value may be about 200 µm. The shape or size of each irregular polygon 133 may be determined within the range of the pitch value P. That is, a plurality of irregular polygons 133 constituting an electrode pattern 130 may have pitch values P of various sizes different from each other within a range of pitch value P of about 140 µm or more to about 260 µm or less.

### (Embodiment 3)

The lower limit value of a pitch value P of an irregular polygon 133 is about 210 µm, and the upper limit value is about 390 µm, and in this case, the reference pitch value may be about 300 µm. The shape or size of each irregular polygon 133 may be determined within the range of the pitch value P. That is, a plurality of irregular polygons 133 constituting an electrode pattern 130 may have pitch values P of various sizes different from each other within a range of pitch value P of about 210 µm or more to about 390 µm or less.

### (Embodiment 4)

The lower limit value of a pitch value P of an irregular polygon 133 is about 245 µm, and the upper limit value is about 455 µm, and in this case, the reference pitch value may be about 350 µm. That is, a plurality of irregular polygons 133 constituting an electrode pattern 130 may have pitch values P of various sizes different from each other within a range of pitch value P of about 245 µm or more to about 455 µm or less. If the range of the pitch value P of the plurality of irregular polygons 133 exceeds the above range, when an irregular polygon having a pitch value P of less than about 245 µm and an irregular polygon having a pitch value P of about 455 µm or more are adjacent to each other, a foreign body sensation may occur in the electrode pattern 130 due to the difference in size between them.

### (Embodiment 5)

The lower limit value of a pitch value P of an irregular polygon 133 is about 280 µm, and the upper limit value is about 520 µm, and in this case, the reference pitch value may be about 400 µm. The shape or size of each irregular polygon 133 may be determined within the range of the pitch value P. That is, a plurality of irregular polygons 133 constituting an electrode pattern 130 may have pitch values P of various sizes different from each other within a range of pitch value P of about 280 µm or more to about 520 µm or less. If the range of the pitch value P of the plurality of irregular polygons 133 exceeds the above range, when an irregular polygon having a pitch value P of less than about 280 µm and an irregular polygon having a pitch value P of about 520 µm or more are adjacent to each other, a foreign body sensation may occur in the electrode pattern 130 due to the difference in size between them.

### (Embodiment 6)

The lower limit value of a pitch value P of an irregular polygon 133 is about 315 µm, and the upper limit value is about 585 µm, and in this case, the reference pitch value may be about 450 µm. That is, a plurality of irregular polygons 133 constituting an electrode pattern 130 may have pitch values P of various sizes different from each other within a range of pitch value P of about 315 µm or more to about 585 µm or less. If the range of the pitch value P of the plurality of irregular polygons 133 exceeds the above-described range, a foreign body sensation may occur in the electrode pattern 130.

### (Embodiment 7)

The lower limit value of a pitch value P of an irregular polygon 133 is about 350 µm, and the upper limit value is about 650 µm, and in this case, the reference pitch value may be about 500 µm. The shape or size of each irregular polygon 133 may be determined within the range of the pitch value P. That is, a plurality of irregular polygons 133 constituting an electrode pattern 130 may have pitch values P of various sizes different from each other within a range of pitch value P of about 350 µm or more to about 650 µm or less. If the range of the pitch value P of the plurality of irregular polygons 133 exceeds the above-described range, a foreign body sensation may occur in the electrode pattern 130.

As such, the reference pitch value may be a value selected from 100 to 500 µm, and the range of the pitch value P of the plurality of irregular polygons 133 may be determined according to the reference pitch value as described above, and the reason lies in the electrical and optical properties of a touch screen device formed of a mesh. The touch screen device requires to be located on top of the display device to have a transmittance higher than a certain value, and requires low sheet resistance to realize high touch sensitivity upon touch.

The transmittance and sheet resistance depend on the size of the pitch value in the mesh, and generally, the size of the pitch value, the size of the transmittance, and the size of the sheet resistance of the electrode pattern 130 each have a proportional value. When the reference pitch value of the electrode pattern 130 is about 100 µm, the transmittance has a value of about 80%, and the sheet resistance shows a value of about 1 Ω□. In addition, when the reference pitch value is about 500 µm, it has a transmittance of about 87% and a sheet resistance of about 7 Ω□. What can be seen from these contents is that as the size of the pitch value increases, there is a gain in transmittance, but due to the correspondingly increased sheet resistance value, a lower value may be shown in comparison to a mesh with a small pitch in the touch sensitivity part.

In addition, by distributing the pitch value P of the irregular polygon 133 within a predetermined range, it is possible to prevent the irregular polygons 133 having a relatively large size or small size than the surroundings from occurring or agglomerating in a non-specific region of the electrode pattern 130, and to prevent the non-specific region of the electrode pattern 130 from appearing more prominent than the surroundings. That is, it is possible to prevent a foreign body sensation occurring at the boundary of the irregular polygons 133 due to the size difference. In this case, since the sheet resistance of the electrode pattern 130 decreases as the reference pitch value approaches about 100 µm, touch sensitivity may be improved, and since the light transmittance increases as the reference pitch value approaches about 500 µm, the screen of the display to which the screen device is applied may become brighter.

Meanwhile, the shape of the electrode pattern 130 formed as described above may be designed using, for example, a predetermined design program. At this time, designing the entire shape of the electrode pattern 130 at once with the predetermined design program described above causes a significant computational load. Accordingly, referring to FIG. 11, the electrode pattern 130 according to the first embodiment of the present invention may include a plurality of unit mesh blocks A arrayed with each other.

That is, in the embodiment of the present invention, the entire area of the electrode pattern 130 may be blocked into unit mesh blocks A having the same size, the shape of the mesh pattern for the blocked unit mesh block A may be designed, and the designed shape may be arrayed to form the shape of one electrode pattern 130 connected to each other. In this case, the size of the plurality of unit mesh blocks A may be determined, for example, according to the number of mesh objects in the block. Here, the number of objects of the mesh in the block is determined according to the number of meshes (polygons) in the block, where the appropriate number of objects is about 40,000 or more to about 250,000 or less. If the number of such objects are implemented as a block in the form of a square, the size of the block size may be up to 5 cm X 5 cm. In detail, the block size may be 1 cm X 1 cm or more and 5 cm X 5 cm or less. The block size may be selected, for example, from 1 cm X 1 cm to 5 cm X 5 cm. Of course, the block size may vary within the range of 5 cm X 5 cm or less.

The shape of this block uses a block in the form of a square in which the length of the side per area can be set optimally, but it is possible to use a block of another shape in addition to the square shape. The determination of the number of objects and the appropriate number of block sizes above was determined based on a computing ability in a general design PC, and when the appropriate number of objects exceeds the appropriate number, a problem may occur in calculation during design.

In this case, in order to prevent a boundary of the unit mesh block A from being visually recognized, irregular polygons forming a boundary between the unit mesh blocks A at the outermost portions of each of the plurality of unit mesh blocks A may have different shapes and sizes. That is, the shape and size of irregular polygons of the boundary lines of the plurality of unit mesh blocks A may be corrected.

Specifically, the shape and size of the irregular polygons 133 may be corrected so that the lengths of the sides S of the irregular polygons 133 located at the boundary lines of the unit mesh blocks A and the extension direction r thereof are different from each other, and the shapes of the irregular polygons 133 may be corrected so that the angles θ formed by adjacent sides S around each vertex V are different. Such a correction is referred to as block boundary line correction, and by this, it is possible to fundamentally prevent a foreign body sensation from occurring at the boundary of the unit mesh block A, and each unit mesh block A may be arrayed naturally or smoothly. That is, due to the computing capability of the design PC, it is difficult to design the entire shape of the electrode pattern 130 at once, and thus after designing the shape of each unit mesh block (A), they should be arrayed to design them into one electrode pattern 130 shape.

In this case, if the block boundary line correction is not performed, although the pitch values of the irregular polygons 133 adjacent to each other in each unit mesh block A are different from each other, when looking at the boundary of the unit mesh blocks A, there may be a case where the pitch values of the irregular polygons 133 adjacent to each other are the same, and thus, the boundary of the unit mesh blocks (A) can be visually recognized.

On the other hand, when designing the shape of each unit mesh block (A) and then arraying them to design the shape of one electrode pattern 130, if the block boundary line correction is performed, each pitch value of irregular polygons 133 adjacent to each other on the entire surface of the electrode pattern 130 may be different from each other, and thus, it is possible to prevent the boundary of unit mesh blocks A from being visually recognized.

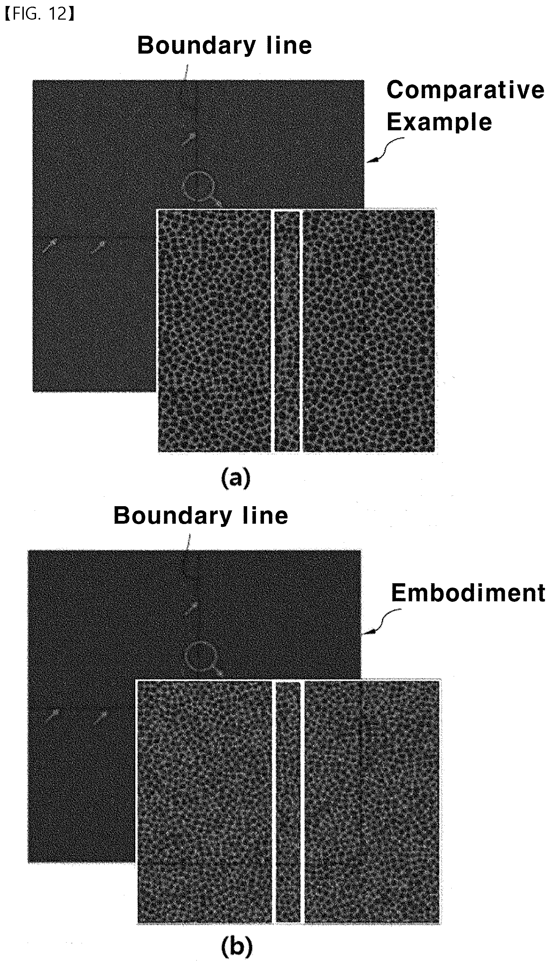

FIG. 12 is a photograph contradistinctively showing an electrode pattern according to an embodiment of the present invention and a comparative example thereof. FIG. 12(a) is an electrode pattern according to a comparative example of the present invention, wherein the pitch value ranges from about 70 µm or more to about 130 µm or less, the line width and depth of each mesh line are each about 10 µm, and block boundary line correction is not performed, thus pitch values of at least some of the irregular polygons adjacent to each other near the boundary of the unit mesh block are the same. Looking at the boundary line of the mesh pattern according to the comparative example, it can be seen that irregular polygons having a relatively small size appear clumped together, and it can be seen that a linear shade is visually recognized on the mesh pattern due to the difference in size.

On the other hand, FIG. 12(b) is an electrode pattern 130 according to an embodiment of the present invention, wherein the pitch value ranges from about 70 µm or more to about 130 µm or less, the line width and depth of each mesh line are each about 10 µm, and block boundary line correction is performed, thus pitch values of irregular polygons adjacent to each other on the entire surface of the electrode pattern 130 are different from each other. As shown in the photograph, it can be seen that the pitch values of the plurality of irregular polygons 133 have a deviation of about ± 30% with respect to the reference pitch value, and thus, the agglomeration phenomenon of the irregular polygon due to the size difference does not occur as a whole of the mesh pattern, and also, the agglomeration phenomenon described above does not occur even at the boundary between the blocks. That is, in the embodiment of the present invention, it can be seen that no linear shade is formed on the mesh pattern.

Meanwhile, the boundary line described above refers to a boundary line of a unit mesh block forming an electrode pattern.

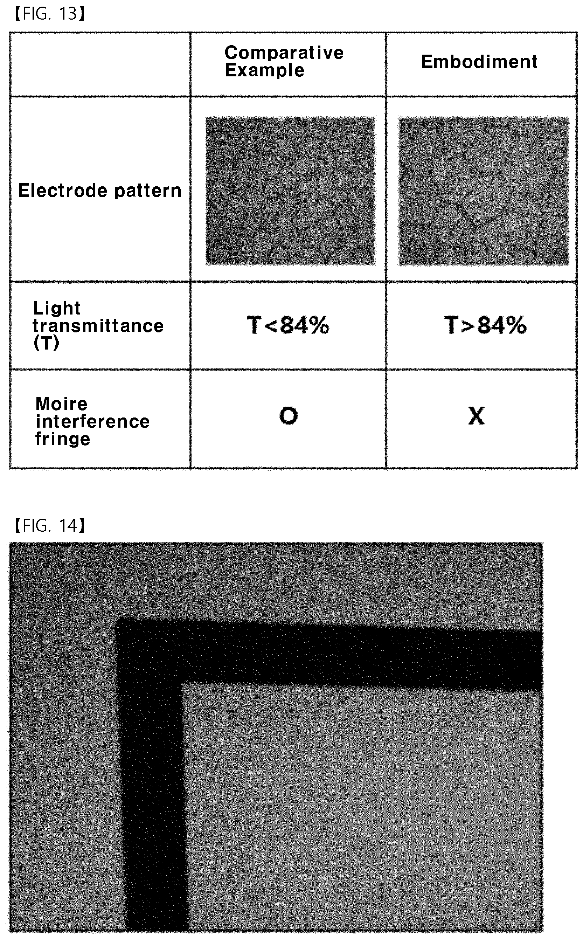

FIG. 13 is a view contradistinctively showing characteristics of a screen device according to an embodiment of the present invention and a comparative example thereof. That is, FIG. 13 is a table contradistinctively showing the light transmittance of the screen device according to the present invention and the comparative example. Here, the light transmittance is a transmittance with respect to the intensity of light passing through the screen device, and it means that the larger the size, the better transmits light.

The comparative example of FIG. 13 is a mesh pattern formed of irregular polygons that do not limit an upper limit value and a lower limit value of a pitch value using a reference pitch value, and is a mesh pattern including irregular polygons having a center value of the pitch value of about 100 µm, a predetermined range of the pitch value outside a range of the pitch value of about 70 µm or more to about 130 µm or less, and a line width and a depth of a mesh line of about 10 µm, respectively. The embodiment of FIG. 13 is a mesh pattern formed of irregular polygons that limit an upper limit value and a lower limit value of a pitch value using a reference pitch value, and is a mesh pattern including irregular polygons having the reference pitch value of about 100 µm, a predetermined range of the pitch value within a range of the pitch value of about 70 µm or more to about 130 µm or less, and a line width and a depth of a mesh line of about 10 µm, respectively.

Comparing the light transmittance of the screen device including the electrode pattern according to the comparative example of FIG. 13 and the screen device including the electrode pattern according to the embodiment, the light transmittance of the comparative example is less than 84%, and the light transmittance of the embodiment is greater than 84%. That is, it can be seen that the case of the embodiment has a larger light transmittance. This means that the screen device of the embodiment better transmits the screen of the display.

The reason for the difference in light transmittance between the comparative example and the embodiment is because in the case of the comparative example, the difference between the upper limit value and lower limit value of the pitch value is large, so irregular polygons with relatively small pitch values appear more prominent compared to their surroundings, shadows are generated and deepened in the corresponding portion, and the shadows and pixel patterns of the display mutually interfere to form moire interference fringes. On the other hand, in the case of the first embodiment, as the upper limit value and lower limit value of the pitch value are limited to have a deviation of about ± 30% from the reference pitch value, and the pitch value is variously distributed within the limited range, it is possible to prevent excessive irregularity while eliminating the repetition of regular shapes in the electrode pattern, fundamentally prevent moire interference fringes due to size differences, and improve visibility.

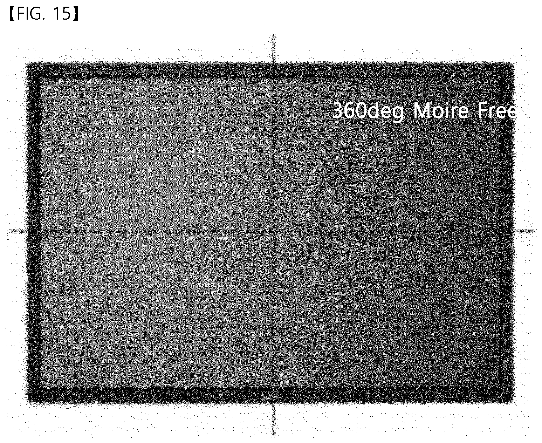

FIG. 14 is a photograph for describing whether a moire phenomenon occurs in a screen device according to an embodiment of the present invention, and FIG. 15 is a photograph showing a display to which a screen device according to an embodiment of the present invention is applied. Here, the dark color portion of FIG. 14 is a bezel portion of a display device, and the light color portion inside the dark color bezel portion is a screen portion of a display, and FIG. 14 is a photograph of a display photographed through a screen device according to an embodiment of the present invention.

In the comparative example, since irregular polygons may be densely formed at an irregular position in the electrode pattern and shadows may occur, a moire phenomenon may be severe depending on how the angle is determined on the display. On the other hand, in the case of the embodiment, since the concentration of irregular polygons at irregular positions in the mesh pattern and the occurrence of shadows can be fundamentally prevented, a moire interference fringe is not generated even if the screen device is overlapped on the display as shown in FIG. 14. Accordingly, as shown in FIG. 15, in an embodiment of the present invention, it may be confirmed that even if the screen device is rotated in all directions of 360 degrees, the moire phenomenon may be avoided in all directions and good visibility may be secured.

The electromagnetic wave shielding films 100 and 200 according to the present invention configured as described above have improved shielding performance. That is, the electromagnetic wave shielding films 100 and 200 according to the present invention may not only exhibit improved electromagnetic wave shielding performance in any electromagnetic wave frequency band generated in the applied product, but also may integrally block electromagnetic waves in a complex product or various fields with a high shielding rate regardless of the frequency band.

In addition, if the electrode patterns 130 and 230 of the electromagnetic wave shielding films 100 and 200 according to the present invention include the irregular polygon 133, a moire phenomenon may be avoided at all angles of a plane by preventing mutual interference with a pixel pattern of the display, and visibility may be improved. In addition, the irregular polygon 133 may suppress pattern agglomeration of the electrode patterns 130 and 230 to distribute the electrode patterns 130 and 230 in a more balanced manner, thereby further enhancing the electromagnetic wave shielding effect.

Specifically, since the plurality of irregular polygons 133 have a polygonal shape having at least four or more sides and shapes are different from each other, a problem of viewing a boundary line at all angles of 360 degrees may be resolved while satisfying the optical and electrical characteristics required in the screen device, and a moire phenomenon may be avoided. Accordingly, when the screen device is attached to the front surface of the display device and used as a touch screen device or an electromagnetic wave shielding device, a moire phenomenon caused by a foreign body sensation of a mesh pattern may be fundamentally prevented, and a moire phenomenon may be avoided at all angles of 360 degrees by preventing mutual interference between the pixel pattern of the display device and the electrode pattern 130 of the screen device at all angles regardless of the pixel pattern of the display device, and visibility of the screen device may be improved.

In the detailed description of the present invention, although specific embodiments have been described, it is apparent that various modifications are possible without departing from the scope of the present invention. Therefore, the scope of the present invention is not limited to the described embodiments, and should be defined by the following claims and their equivalents.

### Industrial Applicability

The present invention relates to an electromagnetic wave shielding film, and can provide an electromagnetic wave shielding film having an improved electromagnetic wave shielding rate and at the same time having high electromagnetic wave shielding performance even in various frequency bands of electromagnetic waves, and thus has industrial applicability.

## Claims

1. An electromagnetic wave shielding film, comprising:
a substrate; and
an electrode pattern, which is provided on one surface of the substrate and contains metal particles,
wherein the metal particles comprise first particles having sizes within a first range and second particles having sizes within a second range that is smaller than the first range, the number of second particles is greater than the number of first particles, and at least one first particle is mixed in among the second particles.

2. An electromagnetic wave shielding film, comprising:
a substrate;
an electrode pattern, which is provided on one surface of the substrate and contains metal particles; and
a transparent conductive layer provided on one surface of the electrode pattern or on the other surface of the substrate and covering the electrode pattern arranged along one surface of the substrate,
wherein the metal particles comprise first particles having sizes within a first range and second particles having sizes within a second range that is smaller than the first range, the number of second particles is greater than the number of first particles, and at least one first particle is mixed in among the second particles.

3. The electromagnetic wave shielding film of claim 1 or claim 2, wherein the electrode pattern comprises a first structure in which a plurality of second particles surround the first particle.

4. The electromagnetic wave shielding film of claim 3, wherein the electrode pattern further comprises a second structure in which a plurality of second particles are connected.

5. The electromagnetic wave shielding film of claim 4, wherein the electrode pattern comprises a greater number of the second structures than the number of the first structu res.

6. The electromagnetic wave shielding film of claim 1 or claim 2, wherein the size of the first range is 2 times or more larger than the size of the second range.

7. The electromagnetic wave shielding film of claim 1 or claim 2, wherein the size of the first range is from 1 µm or more to 1.5 µm or less, and the size of the second range is from 400 nm or more to 450 nm or less.

8. The electromagnetic wave shielding film of claim 1 or claim 2, wherein the number ratio between the first particles and the second particles is 2:8 to 4:6.

9. The electromagnetic wave shielding film of claim 1 or claim 2, wherein the electrode pattern is formed in a mesh pattern shape comprising a plurality of polygons arranged along one surface of the substrate.

10. The electromagnetic wave shielding film of claim 9, wherein the plurality of polygons comprise a plurality of irregular polygons adjacent to each other, and the irregular polygons have different pitch values between adjacent irregular polygons.

11. The electromagnetic wave shielding film of claim 10, wherein the irregular polygon has four or more vertexes, and a direction in which each of the sides extends is different from each other.

12. The electromagnetic wave shielding film of claim 10, wherein the irregular polygon has different angles formed by adjacent sides around each of the vertexes.

13. The electromagnetic wave shielding film of claim 1 or claim 2, wherein the electrode pattern is formed along a groove formed on one surface of the substrate or on one surface of a resin layer provided on one surface of the substrate.

14. The electromagnetic wave shielding film of claim 2, wherein the metal particles are any one selected from silver (Ag), copper (Cu), aluminum (Al), nickel (Ni), and chromium (Cr), and the conductive layer is any one selected from ITO, silver (Ag) nanotubes, graphene, carbon nanotubes, silver (Ag) particles, or a conductive polymer.

15. The electromagnetic wave shielding film of claim 1 or 2, wherein the substrate is transparent and can be employed as a light-transmitting screen device in a display.
